# EUROPEAN PATENT APPLICATION

(11) **EP 1 591 551 A1**
(43) Date of publication of application: **02.11.2005**
(21) Application number: 04705171.9
(22) Date of filing: 26.01.2004
(51) Int. Cl.: C23C 8/36

(54) **ALUMINUM MATERIAL HAVING AlN REGION ON THE SURFACE THEREOF AND METHOD FOR PRODUCTION THEREOF**

(30) Priority: 24.01.2003 JP 2003015629
(71) Applicant: Research Institute for Applied Sciences, Kyoto-shi, Kyoto 606-8202 (JP); Aizawa, Tatsuhiko, Tokyo 201-0004 (JP)
(72) Inventor: AIZAWA, Tatsuhiko, 2010004 (JP); KUWAHARA, Hideyuki, c/o Rch. Inst. for Applied Scs, Kyoto-shi, Kyoto 606-8202 (JP)
(74) Representative: Reitstötter - Kinzebach
(86) International application number: PCT/JP2004/000642
(87) International publication number: WO 2004/065653

(57) **Abstract**

An aluminum material having, on the surface thereof, an AlN region which has enhanced film thickness, is uniform within the region and exhibits a high adhesion to a base material; and a method for producing the aluminum material, which comprises a step of providing an aluminum material comprising CuAl₂, and a step of subjecting said aluminum material to plasma nitriding, to thereby form the aluminum nitride (AlN) region on the surface of the aluminum material.

## Description

### Technical Field

The present invention relates to a process of producing a thick aluminum nitride on the surface of an aluminum material in a short time and to an aluminum material having a thick aluminum nitride region on the surface thereof.

### Background Art

Conventionally, various methods have been proposed to develop wear resistance by forming an aluminum nitride on the surface of an aluminummaterial or aluminum alloy. For instance, Japanese Patent Application Laid-Open (JP-A) No. 60-211061 (Reference 1) discloses a process of producing an aluminum material having an aluminum nitride layer, in which the process comprises a step of activating the surface of a material such as aluminum to be treated and a step of ion-nitriding the surface to be treated by glow discharge to form an aluminum nitride layer on the surface.

Also, JP-A No. 5-179420 (Reference 2) discloses a method which improves the drawbacks of JP-A No. 60-211061, i.e., decreased thickness of AlN, unevenness of wear resistance and insufficient adhesion between AlN and a base material. Briefly, JP-A No. 5-179420 discloses an aluminum material comprising a base material such as aluminum, an Al-Ag intermetallic compound layer formed on the surface of the base material and an AlN layer formed on the intermetallic compound layer, with improved wear resistance.

However, the Reference 1 could not provide the AlN layer having sufficient thickness, since the Reference 1 could provide the AlN layer having several tens µm at most, which is actually limited to about several µm, as described in the Reference 2. Also, it takes longer time, e.g. , 24 hours to form the AlN layer having a thickness of several µm to several tens µm, and thus, the method was undesirable also in view of cost. Since the resultant AlN layer is uneven, desired wear resistance cannot be obtained. The AlN layer also has low adhesion to aluminum to be treated, so that peeling is observed. Therefore, the Reference 1 could not provide desired one in this point of view.

Also, the method of the Reference 2 somewhat improves the drawbacks of the Reference 1. However, the method of the Reference 2 has the problem that cracks occur when the film thickness of AlN exceeds 10 µm (Reference 2 [0036]). Also, since Ag is used for the intermediate layer, the method is undesirable in view of cost. Further, the method of the Reference 2 is limited in selecting materials as follows: 1) the aluminum material should contain silver and 2) the intermediate layer containing silver should be precipitated "film-wise". In addition to the limitations, this method also has the problem that the adhesive strength of the base material, aluminum material to AlN depends on the intermediate layer, through which AlN is formed, leading to a loss of selectivity of mechanical strength.

### Disclosure of Invention

An obj ect of the present invention is to solve the problem possessed by conventional processes of producing an aluminum material having an AlN layer on the surface thereof.

Specifically, an object of the present invention is to provide a process of producing an aluminum material having a thick AlN region on the surface thereof in a short time. In particular, other than or in addition to the above-mentioned obj ects, an obj ect of the present invention is to provide a process of producing an aluminum material having a thick AlN region on the surface thereof, wherein the AlN region is uniform within the region and has high adhesion to a base material.

Other than or in addition to the above-mentioned objects, another obj ect of the present invention is to provide an aluminum material having a thick AlN region on the surface thereof, in particular, to provide an aluminum material having an AlN region on the surface thereof wherein the AlN region has enhanced film thickness, is uniform within the region and has high adhesion to a base material.

The present inventors have found that CuAl₂ is effective to help the nucleation and growth of AlN. The present inventors have found that an aluminum material having an AlN region on a predetermined area of the surface thereof can be provided by using, as a base material, an aluminum material containing CuAl₂. Specifically, the present inventors have found the following inventions:
<1> A process of producing an aluminum material having an aluminum nitride (AlN) region on the surface thereof, comprising the steps of:
   preparing an aluminum material containing CuAl₂; and
   plasma nitriding the aluminum material, to thereby form an AlN region on the surface of the aluminum material.
<2> In the above item <1>, the process may further comprise a step of sputtering the aluminum material to remove Al₂O₃ present on the surface of the aluminum material prior to the plasma nitriding step.
<3> In the above item <1> or <2>, the plasma nitriding step may be carried out at -167 to 630°C, preferably -167 to 550°C, more preferably -167 to 450°C.
<4> In any one of the above items <1> to <3>, the plasma nitriding step may comprise a treating step which consists of a step of applying a pulse voltage of -50 V to -50 kV for 0.1 µs to 10 ms followed by a application suspending step having 0.1 µs to 100 ms; or the plasma nitriding step may comprise a treating step which comprises a step of applying a continuous D.C. voltage of -50 to -800 V, in an activated first nitriding gas atmosphere.
<5> In the above item <4>, the first nitriding gas may be a gas made from nitrogen and hydrogen and/or a gas comprising nitrogen gas and hydrogen gas. In the case where the first nitriding gas is a gas made from nitrogen and hydrogen, the first nitriding gas may be NH₃ or mixed gas consisting of NH₃ and inert gas. In the case where the first nitriding gas is a gas comprising nitrogen gas and hydrogen gas, partial pressure of nitrogen gas may be 0.01 to 40 Torr and partial pressure of hydrogen gas may be 0.01 to 100 Torr. More preferably, the first nitriding gas may have 1: 3 of partial pressure ratio of nitrogen gas to hydrogen gas, and/or may have 1: 3 of a molar ratio of nitrogen to hydrogen (N:H) .
<6> In any one of the above items <1> to <5>, AlN may be produced at a rate of 0.05 µm/hour or more, preferably 0.5 to 50 µm/hour, in the plasma nitriding step.
<7> In any one of the above items <2> to <6>, the sputtering step may be carried out using the aluminum material as the negative electrode by applying a D.C. voltage of -50 V to -4000 V in an atmosphere of chemically activated second nitriding gas. The second nitriding gas may be nitrogen, and the partial pressure of nitrogen may be 0.01 to 20 Torr.
<8> In any one of the above items <1> to <7>, CuAl₂ may be contained in the AlN region of the obtained aluminum material.
<9> An aluminum material having an AlN region on the surface thereof, wherein the AlN region has CuAl₂.
<10> An aluminum material having an AlN region on the surface thereof, wherein CuAl₂ is finely dispersed in the AlN region.
<11> In the above item <9> or <10>, the AlN region has a thickness of 0.1 µm or more, preferably 2 to 2000 µm, more preferably 4 to 200 µm.
<12> In any one of the above items <9> to <11>, the AlN region may be grown at a rate of 0.05 µm/hour or more, preferably 0.5 to 50 µm/hour.
<13> In any one of the above items <9> to <12>, the AlN region may have a Vickers hardness (Hv) of 4 GPa or more, preferably 7 to 15 GPa, more preferably 7 to 14 GPa.
<14> In any one of the above items <9> to <13>, the AlN region may have a thermal conductivity of 100 W/mK or more, preferably 100 to 340 W/mK.
<15> In any one of the above items <9> to <14>, the tensile fracture strength between the AlN region and the aluminum material may be not less than the tensile fracture strength of the aluminum material and may be 15 GPa or less, preferably 7 to 11 GPa.
<16> A process of producing an aluminum material having an aluminum nitride (AlN) region on the surface thereof, comprising:
   a solution treatment step of subjecting an Al alloy containing Cu to a solution treatment at a solution treatment temperature; and
   an age-precipitation step of subjecting the alloy obtained by the solution treatment step to a heat treatment at an age-precipitation temperature lower than the solution treatment temperature, to precipitate CuAl₂ and to obtain an aluminum material having CuAl₂; and
   a plasma nitriding step of plasma nitriding the aluminum material, to thereby form an AlN region on the surface of the aluminum material.
<17> In the above item <16>, the plasma nitriding step may fill the role(s) of one or both of the solution treatment step and the age-precipitation step, in particular, the role (s) of the age-precipitation step, by controlling a temperature of the plasma nitriding step.
<18> In the above item <16> or <17>, the process may further comprise a step of sputtering the aluminum material to remove Al₂O₃ present on the surface of the aluminum material prior to the plasma nitriding step.
<19> In the above item <18>, the sputtering step may fill the role (s) of one or both of the solution treatment step and the age-precipitation step, in particular, a role of the age-precipitation step, by controlling a temperature of the sputtering step.
<20> In the above item <18> or <19>, the temperature of the sputtering step may be lower by at least 10°C, preferably by 10 to 50°C than the solution treatment temperature, thereby allowing the precipitation morphology and distribution of CuAl₂ in the age-precipitation step not to be changed practically.
<21> In any one of the above items <16> to <20>, the plasma nitriding step may be carried out at -167 to 630°C, preferably -167 to 550°C, more preferably -167 to 450°C.
<22> In any one of the above item <16> to <21>, the temperature of the plasma nitriding step may be lower by at least 10°C, preferably by 10 to 50°C than the age-precipitation temperature, thereby allowing the precipitation morphology and distribution of CuAl₂ in the age-precipitation step not to be changed practically.
<23> In any one of the above items <16> to <22>, the plasma nitriding step may comprise a treating step which consists of a step of applying a pulse voltage of -50 V to -50 kV for 0.1 µs to 10 ms followed by a application suspending step having 0.1 µs to 100 ms; or the plasma nitriding step may comprise a treating step which comprises a step of applying a continuous D.C. voltage of -50 to -800 V, in an activated first nitriding gas atmosphere.
<24> In the above item <23>, the first nitriding gas may be a gas made from nitrogen and hydrogen and/or a gas comprising nitrogen gas and hydrogen gas. In the case where the first nitriding gas is a gas made from nitrogen and hydrogen, the first nitriding gas may be NH₃ or mixed gas consisting of NH₃ and inert gas. In the case where the first nitriding gas is a gas comprising nitrogen gas and hydrogen gas, partial pressure of nitrogen gas may be 0.01 to 40 Torr and partial pressure of hydrogen gas may be 0.01 to 100 Torr. More preferably, the first nitriding gas may have 1:3 of partial pressure ratio of nitrogen gas to hydrogen gas, and/or may have 1: 3 of a molar ratio of nitrogen to hydrogen (N:H).
<25> In any one of the above items <16> to <24>, AlN may be produced at a rate of 0.05 µm/hour or more, preferably 0.5 to 50 µm/hour, in the plasma nitriding step.
<26> In any one of the above items <18> to <25>, the sputtering step may be carried out using the aluminum material as the negative electrode by applying a D.C. voltage of -50 V to -4000 V in an atmosphere of chemically activated second nitriding gas. The second nitriding gas may be nitrogen, and the partial pressure of nitrogen may be 0.01 to 20 Torr.
<27> In any one of the above items <16> to <26>, CuAl₂ may be contained in the AlN region of the obtained aluminum material.

### Brief Description of the Drawings

Fig. 1 is a SEM image of Al-6Cu showing the presence of CuAl₂ .
Fig. 2 is a SEM image of Al-6Cu-0.5Mg showing the presence of CuAl₂.
Fig. 3 is a SEM image of Al-6Cu-2Mg showing the presence of CuAl₂.
Fig. 4 is a graph showing the results of X-ray diffraction analysis (incident angle: 1°) of B-2 (sputtering time: 0. 5 hours) and B-5 (sputtering time: 2 hours) which are prepared using an Al-6Cu-0.5Mg alloy as a base material.
Fig. 5 is a graph showing the results of X-ray diffraction analysis (incident angle: 1°) of B-3 prepared using an Al-6Cu-0.5Mg alloy and B-6 prepared using an Al-6Cu alloy as a base material.
Fig. 6 is a graph showing the results of X-ray diffraction analysis (incident angle: 1°) of B-5 prepared using an Al-6Cu-0.5Mg alloy, B-7 prepared using an Al-6Cu alloy and B-8 prepared using an Al-6Cu-2Mg alloy as a base material.
Fig. 7 is a graph showing the results of X-ray diffraction analysis (incident angle: 1°) of B-1 to B-4 (time: 2, 4, 6 and 8 hours) prepared using an Al-6Cu-0. 5Mg alloy as a base material by changing the time required for plasma nitriding treatment.
Fig. 8 is a sectional SEM image of B-2 (plasma nitriding treatment time: 4 hours) prepared using an Al-6Cu-0. 5Mg alloy as a base material.
Fig. 9 is a graph showing a sectional SEM image of B-3 (plasma nitriding treatment time: 6 hours) prepared using an Al-6Cu-0.5Mg alloy as a base material.
Fig. 10 is a view showing the results of measurement of the hardness (Vickers Hardness) of each section of B-2 and B-3.

### Best Mode for Carrying Out the Invention

Hereinafter, the present invention will be described in detail.

The present invention provides a process of producing an aluminum material having an aluminum nitride (AlN) region on the surface thereof, the process comprising a step of preparing an aluminum material containing CuAl₂ and a step of plasma-nitriding the aluminum material to thereby form an AlN region on the surface of the aluminum material.

The present inventors have found that the presence of CuAl₂, which helps the nucleation and growth of AlN in the aluminum material used as a base material, is effective to form a thick AlN layer in a short time and to form an AlN layer having high adhesion to the base material.

The aluminum material used as the base material contains CuAl₂. The amount of CuAl₂ contained in the aluminum material (base material) depends on the desired area of the AlN region on the surface of the aluminum material, the conditions of plasma nitriding treatment (for example, treating time and treating temperature) and the like. The aluminum material used as the base material preferably contains CuAl₂ so that the amount of Cu is 55 mass% or less, preferably 0.5 to 6 mass% when the total amount of the aluminum material is 100 mass%; or the vol% of CuAl₂ is 10 vol% or less, preferably 0.5 to 6.5 vol% when the total volume of the aluminum material is 100 vol%.

As mentioned above, the present inventors have found that AlN-nucleation and AlN-growth are accommodated by a helper, CuAl₂. Therefore, if CuAl₂ which is to help the AlN-growth, for example, uniformly dispersed in the aluminum material (base material), AlN can grow on CuAl₂ uniformly dispersed as a nucleation site. Therefore, it is possible to form an AlN layer having uniform thickness on the entire surface of the aluminum material by carrying out plasma nitriding treatment for a predetermined time. Also, CuAl₂, nucleation site of AlN, arranged in a straight-line on the surface of the aluminum material (base material) can form a linear or band AlN layer (AlN region) on the surface of the aluminum material.

"A step of preparing an aluminum material containing CuAl₂" involves a step of treating the aluminum base material so that the aluminum material as the base material is made to contain CuAl₂ when it originally contains no CuAl₂. Examples of the aluminum base material containing no CuAl₂ may include aluminum alloys containing copper and aluminum alloys containing copper and alloy elements other than copper. "The step of preparing an aluminum material containing CuAl₂" involves a step of using a commercially available aluminum alloy containing CuAl₂ as it is.

Examples of the aluminum material having CuAl₂ may include, but are not limited to, Al-6Cu, Al-6Cu-0.5Mg, Al-6Cu-2Mg, Al-(0.2-55)Cu-(0.05-1)Ti,
Al-(0.2-55) Cu- (0.1-10) Mg- (0.05-1) Ti, and the like. A step of treating an aluminum base material so as to make the base material contain CuAl₂ allows the aluminum material to be designed such that CuAl₂ is arranged to have various morphology and distribution as mentioned above.

When the material to be used contains no CuAl₂, "the step of preparing an aluminum material containing CuAl₂" preferably involves the following steps (1) to (4) to "prepare an aluminum material containing CuAl₂" : (1) a step (melting and casting step) of melting and casting an Al alloy (Al-Cu alloy) containing Cu; (2) a forging and rolling step; (3) a solution treatment step; and (4) an age-precipitation step.

Here, the melting and casting step (1) is a step where a material to be used is a pure Al or Cu material and a step of producing an aluminum alloy containing Cu, for example, an Al-Cualloy. The forging and rolling step (2) is a step of forging and/or rolling the resulting Al alloy.

Also, the solution treatment step (3) is a step of preparing a supersaturated solid solution at ambient temperature in the following manner: an Al alloy is heated to a temperature (solution treatment temperature) higher than the melting temperature of elements (for example, Cu in the case of an Al-Cu alloy) other than Al to melt the elements other than Al into a supersaturated solid solution, and after the solution treatment step is sufficiently completed, the solid solution is cooled rapidly at such a cooling rate not to segregate the elements other than Al or not to precipitate any crystals containing these elements. In the case of, for example, an Al-Cu alloy, the cooling speed in the solution treatment step is decreased (gradually cooled) whereby the aluminum material containing CuAl₂ can be prepared, without using the age-precipitation step (4).

The age-precipitation step (4) is a step of precipitating CuAl₂ by keeping a temperature lower than the solution treatment temperature in the solution treatment step (3) under heating. Generally, the age-precipitation step (4) makes it possible to prepare the aluminum material containing CuAl₂. Furthermore, CuAl₂ can be precipitated in the sputtering step and/or the plasma nitriding step, as described later, by controlling the conditions such as temperature and/or time in these steps. There is therefore the case where the sputtering step and/or the plasma nitriding step as described later may work as the age-precipitation step, namely, "the step of preparing an aluminum material having CuAl₂".

The aluminum material may be a bulk or powder form. The powder form used herein means materials ranging from chip materials having an average particle diameter of about 1 mm to powders having an average particle diameter of 1 µm. Therefore, the present invention can provide an aluminum powder form material having an AlN region in a predetermined area of the surface thereof and also an aluminum bulk material having an AlN region in a predetermined area of the surface thereof.

After the step of preparing an aluminum material, the aluminum material is subjected to a step of plasma-nitriding the aluminum material. Prior to the plasma nitriding, the aluminum material is preferably subjected to a process of removing Al₂O₃ present on the surface of the aluminum material, for example, a sputtering step.

The process of removing Al₂O₃ may use conventional processes. Examples of the process of removing Al₂O₃ may include, but are not limited to, a reduction using chlorine ions, argon ion sputtering, and the like. In the present invention, the process of removing Al₂O₃ is preferably carried out in the followingmanner because of the relevance to the plasma nitriding treatment that will be carried out afterwards: the aluminum material as the base material is placed in a container, the container is evacuated, then, a D.C. voltage of -50 V to -4000 V is applied by using the aluminum material as the negative electrode under an atmosphere of nitriding gas, preferably 1 Torr nitrogen, to carry out sputtering of the aluminum material for 1 minute to several hours.

The sputtering step is preferably carried out in the atmosphere of chemically activated second nitriding gas. The term "the second nitriding gas" used herein may be only N₂ gas or a mixture of N₂ gas and an inert gas (for example, Ar gas).

As mentioned above, there is the case where the sputtering step may work as "the age-precipitation step", namely, "the step of preparing an aluminum material having CuAl₂", depending on the conditions such as temperature and/or time.

Then, the aluminum material is subjected to a plasma nitriding step. This step ensures that an aluminum nitride (AlN) region is formed on the surface of the aluminum material.

The plasma nitriding step is preferably carried out in the following condition. As to the temperature condition, the plasma nitriding step is carried out at -167 to 630°C, preferably -167 to 550°C, more preferably -167 to 450°C. Also, as to the conditions other than the above temperature, the plasma nitriding step, using the aluminum materials as the negative electrode, includes a treating step involving an application step of applying a pulse voltage of -50 to -50 kV, preferably -50 to -1000 V for 0.1 µs to 10 ms, preferably 0.1 µs to 1 ms followed by the application suspending step carried out for 0.1 µs to 100 ms, preferably 10 µs to 100 ms; or a treating step of applying a continuous D. C. voltage of -50 to -800 V. In the case of performing the treating step involving the application step and the application suspending step, it is preferable to repeatedly carry out this cycle of the application step and application suspending step. The treating step may be carried out for 0. 5 hours or more, for example, 0. 5 to 100 hours, although the treating time differs depending on the desired thickness of AlN.

As mentioned above, there is the case where the plasma nitriding step may work as "the age-precipitation step", namely, "the step of preparing an aluminum material containing CuAl₂", depending on the conditions such as temperature and/or time.

CuAl₂ in the aluminum material is changed in its precipitation morphology and distribution according to the temperatures in the sputtering step and/or the plasma nitriding step. When the temperature in the sputtering step and/or the plasma nitriding step is either close to the temperature in the age-precipitation step (4) (temporarily named as "Tj") or higher than, for example, more than (Tj -10) °C, CuAl₂ in the aluminum material is changed in its precipitation morphology and distribution. Therefore, it is not intended to change the precipitation morphology and distribution of CuAl₂ in the aluminum material in the sputtering step and/or the plasma nitriding step, the temperature in the sputtering step and/or the plasma nitriding step is a temperature lower by at least 10°C ((Tj - 10)°C or less), preferably a temperature lower by 10 to 50°C ((Tj - 10) to (Tj - 50)°C) than that in the age-precipitation step (4) . On the other hand, in the case where CuAl₂ in the aluminum material is allowed to be changed in the precipitation morphology and distribution, it is possible to select a temperature depending on the desired precipitation morphology and distribution.

Also, the atmosphere in the plasma nitriding step is preferably the first nitriding gas atmosphere. Here, the first nitriding gas may be a gas made from nitrogen and hydrogen, and/or a gas comprising nitrogen gas and hydrogen gas. The term "a gas made from nitrogen and hydrogen" means a gas made from an element N and an element H such as NH₃ gas. The term "a gas having a gas comprising nitrogen and hydrogen" means a mixture gas of NH₃ gas and, for example, an inert gas (e.g. , Ar gas). Also, the term "a gas consisting of nitrogen gas and hydrogen gas" may be a gas comprising only H₂ gas and N₂ gas or a gas further comprising, for example, an inert gas (for example, Ar gas) . "The gas having a gas comprising nitrogen and hydrogen" is preferably NH₃ gas or a mixture gas of NH₃ gas and Ar gas. "The gas comprising nitrogen gas and hydrogen gas" is preferably a gas comprising a nitrogen gas partial pressure of 0.01 to 40 Torr and a hydrogen gas partial pressure of 0.01 to 100 Torr. The first nitriding gas may be a gas having, for example, NH₃ gas, H₂ gas and N₂ gas. The first nitriding gas is preferably one in which the partial pressure ratio of nitrogen gas to hydrogen gas is 1:3 or the molar ratio of nitrogen to hydrogen is 1:3.

The plasma nitriding step in the present invention can produce AlN at a rate of 0.05 µm/hour or more, preferably 0.5 to 100 µm/hour.

In particular, the rate of the formation of AlN is 10 to 13 µm/hour in the initial stage of the plasma nitriding step (until four hours from the start of the nitriding step) and 10 to 30 µm/hour in the next stage (4 to 6 hours after the nitriding step) .

According to the above method, the present invention can provide an aluminum material having an AlN region on the surface thereof.

The thickness of the AlN region can be controlled by changing various parameters in the aforementioned method, in particular, by changing the parameters in the plasma nitriding step, for example, plasma nitriding time. For example, the thickness of the AlN region may be designed to be 0.01 µm or more, for example, 2 to 2000 µm, preferably 4 to 200 µm.

The aluminum material obtained by the present invention has an AlN region on the surface thereof. The AlN region contains CuAl₂. CuAl₂ may be present in the AlN region in columnar structure perpendicular to the surface of the aluminum material which is the base material, and/or in fine particles, and/or in film structure at the interface between the formed AlN region and the surface of the aluminum material which is the base material. The morphology of CuAl₂ depends on the condition of the formation of AlN, particularly temperature condition. It is considered that the presence of CuAl₂ makes it possible to promote the growth and formation of AlN.

A material in which CuAl₂ is formed film-wise on the interface between the formed AlN region and the surface of the aluminum material which is the base material, namely, a material provided with the aluminum material layer, CuAl₂ layer and AlN layer which are formed in this order may be used as a heat sink. AlN is an electrical insulator but it has superior thermal conductivity, CuAl₂ and the aluminum material in the inside have high strength and excellent thermal conductivity, and therefore, the material obtained by combining these layers can be used as a heat sink.

Also, the present invention can provide an aluminum material provided with the AlN region having a Vickers hardness (Hv) of 4 GPa or more, preferably 8 to 15 GPa. In particular, the aluminum material obtained by the present invention has a thick AlN region and therefore, not only the surface of AlN but also the Vickers hardness of the section of AlN can be measured.

The AlN region obtained by the present invention has high adhesion to the aluminum material which is the base material. For example, the tensile fracture strength between the AlN region and the aluminum material which is the base material is not less than the tensile fracture strength of the aluminum material, and is 15 GPa or less, preferably 8 to 11 GPa. The phrase "the tensile fracture strength between the AlN region and the aluminum material which is the base material" used herein means, unless stated otherwise, a difference between the Vickers hardness (Hv) of the aluminummaterial which is the base material and the Vickers hardness (Hv) of the AlN region and indicates the strength necessary to peel the AlN region from the aluminum material which is the base material.

Because AlN has a thermal conductivity of 100 to 340 W/mK, the aluminum material obtained by the present invention may be applied as a radiating plate having an AlN region in a predetermined area.

Also, the aluminum material obtained in the present invention and having an AlN region on the surface thereof may be applied to materials used for sliding mechanical parts, automobile engine parts, trial molds for plastic forming, heat sinks for semiconductors and the like.

### Examples

The present invention will be explained in more detail by way of examples, which are not intended to be limiting of the present invention.

### Example 1:

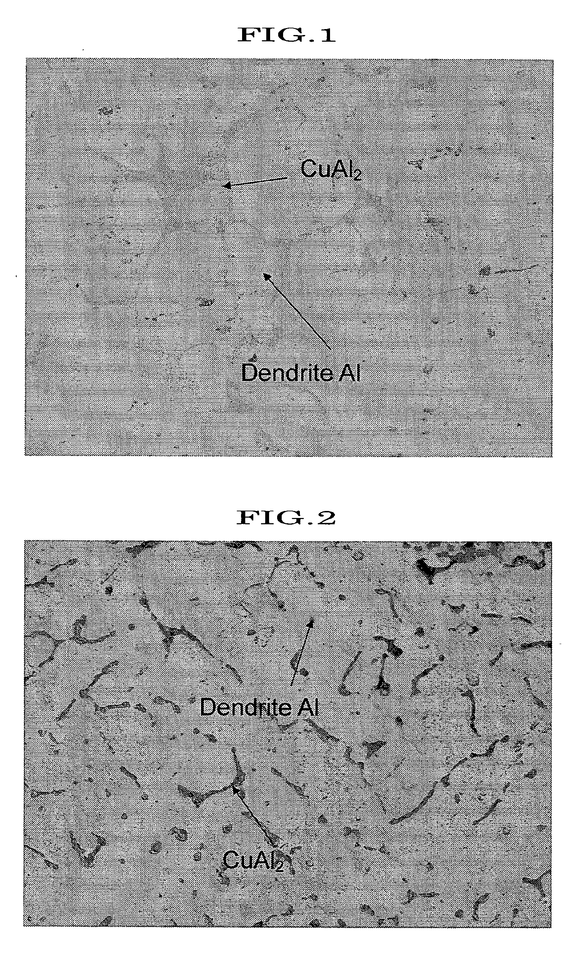

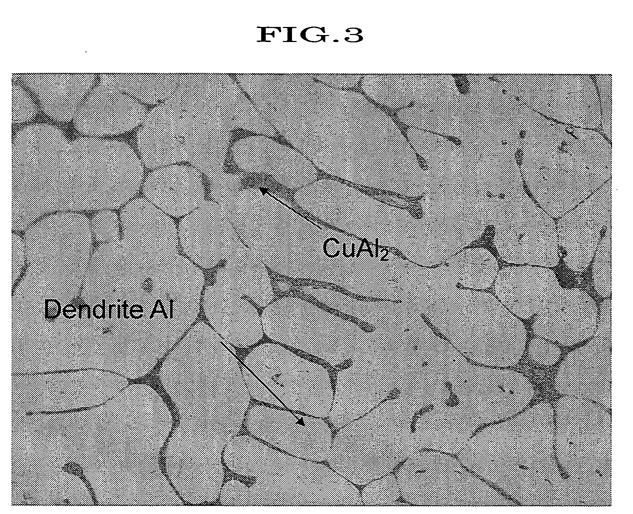

Aluminum alloys A-1 to A-3 shown in Table 1 were respectively prepared in an amount of about 1.3 g (dimension: about 10 mm (thickness) × about 8 mm × about 6 mm) as a base material. Before these aluminum alloys were subjected to the treatment as described later, each SEM image of these aluminum alloys A-1 to A-3 were observed. As a result, CuAl₂ was confirmed in all of these aluminum alloys as shown in Figs. 1 to 3.

**Table 1.**

| Aluminum alloy | Composition |
|---|---|
| A-1 | Al-6Cu |
| A-2 | Al-6Cu-0.5Mg |
| A-3 | Al-6Cu-2Mg |

Each aluminum alloy was disposed in a sealed container and the container was evacuated. Then, the surface of the aluminum alloy was subjected to a sputtering step carried out at 400°C under a 1 torr nitrogen atmosphere. The condition of the sputtering step was as follows: an aluminum alloy was used as the negative electrode, D.C. voltage: -250 to -270 V; 0.1 to 0.2 A; time: 0.5 hours or 2 hours. Thereafter, the aluminum alloy was used as a negative electrode to carry out plasma nitriding treatment under a 1 torr nitrogen (N₂) and 3 torr hydrogen (H₂) atmosphere for 2 hours, 4 hours, 6 hours and 8 hours in the following condition: pulse voltage: -200 V; 0.2 A; and 673 K, thereby obtaining aluminum alloys B-1 to B-8 having an aluminum nitride (AlN) layer on the surface thereof. Furthermore, the pulse voltage was applied repeatedly in the following manner: application: 16 ms and suspension of application: 32 ms. With regard to these aluminum alloys B-1 to B-8, the composition of the base material to be used, and sputtering time and plasma nitriding time to be used are shown in Table 2.

**Table 2.**

| | Base material | Sputtering time (h) | Plasma nitriding time (h) | Remarks |
|---|---|---|---|---|
| B-1 | Al-6Cu-0.5Mg | 0.5 | 2 | Fig. 7 |
| B-2 | Al-6Cu-0.5Mg | 0.5 | 4 | Figs. 4 & 7 |
| B-3 | Al-6Cu-0.5Mg | 0.5 | 6 | Figs. 5 & 7 |
| B-4 | Al-6Cu-0.5Mg | 0.5 | 8 | Fig. 7 |
| B-5 | Al-6Cu-0.5Mg | 2 | 4 | Fig. 4 |
| B-6 | Al-6Cu | 0.5 | 6 | Fig. 5 |
| B-7 | Al-6Cu | 2 | 4 | Fig. 6 |
| B-8 | Al-6Cu-2Mg | 2 | 4 | Fig. 6 |

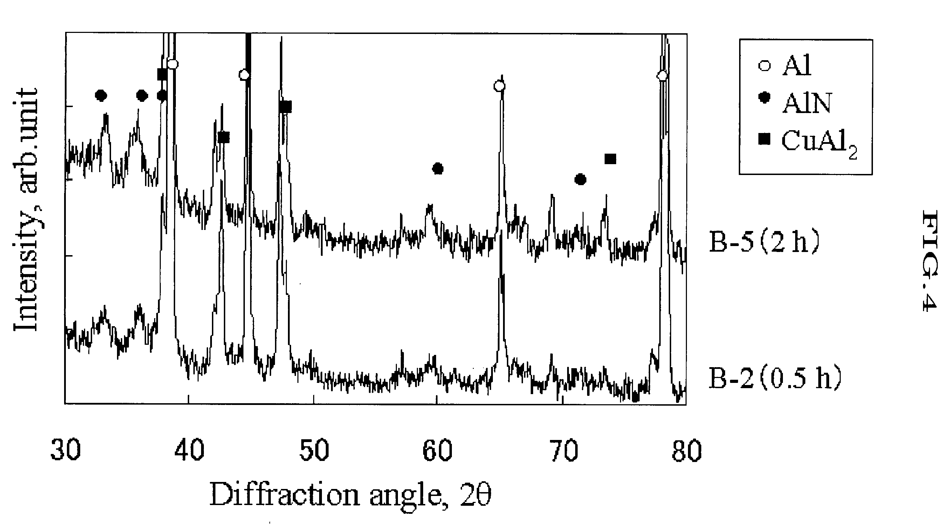

Fig. 4 is a graph showing the results of X-ray diffraction analysis (incident angle: 1°) of B-2 (sputtering time: 0.5 hours) and B-5 (sputtering time: 2 hours) which are prepared using an Al-6Cu-0.5Mg alloy as a base material. In both of B-2 and B-5, the presence of AlN was confirmed. It is found from the results that even if the time of the sputtering, which is pretreatment for removing Al₂O₃, is short, AlN can be formed on the surface of the aluminum material.

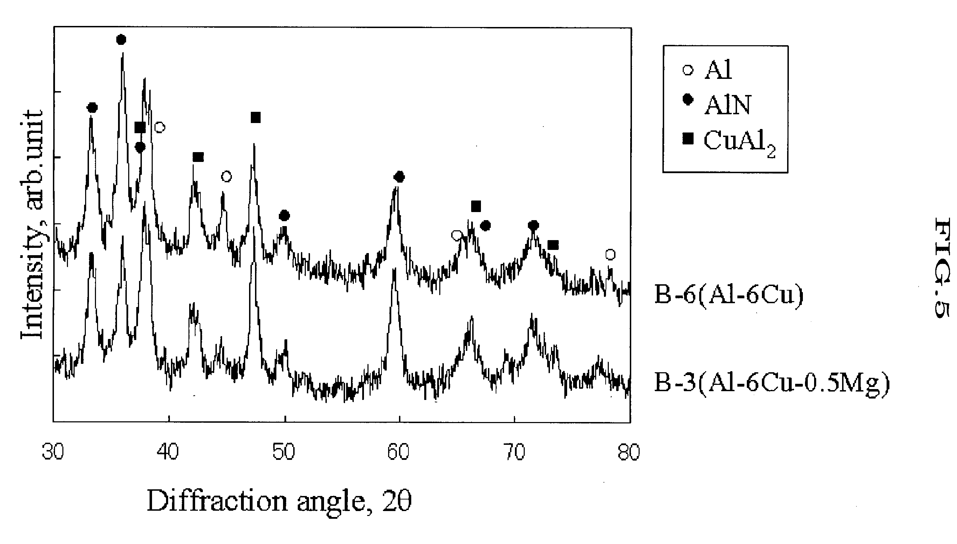

Fig. 5 is a graph showing the results of X-ray diffraction analysis (incident angle: 1°) of B-6 (Al-6Cu) and B-3 (Al-6Cu-0.5Mg) which are prepared using an Al-6Cu alloy or an Al-6Cu-0 . 5Mg alloy as a base material. The presence of AlN was confirmed in both B-3 and B-6.

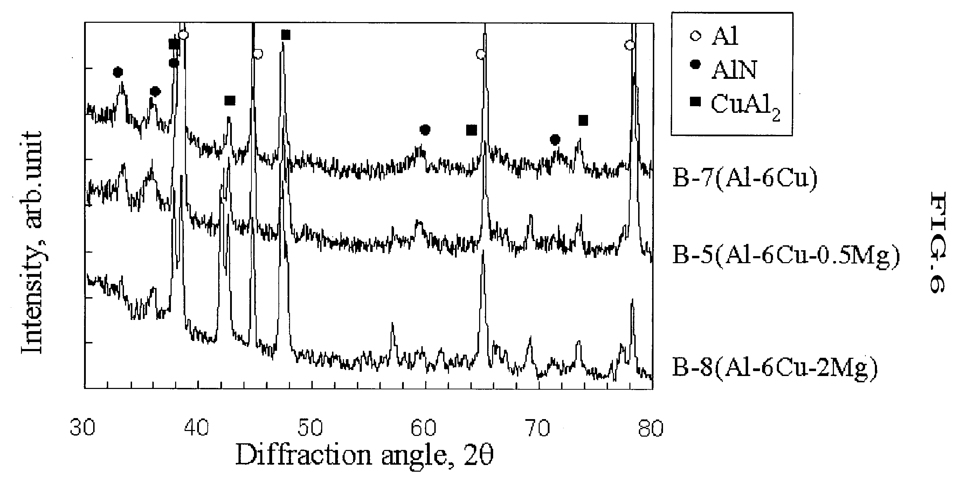

Fig. 6 is a graph showing the results of X-ray diffraction analysis (incident angle: 1°) of B-7 (Al-6Cu), B-5 (Al-6Cu-0.5Mg) and B-8 (Al-6Cu-2Mg) prepared using an Al-6Cu alloy, an Al-6Cu-0.5Mg alloy or an Al-6Cu-2Mg alloy as a base material. The presence of AlN was confirmed in any of B-5, B-7 and B-8.

Fig. 5 and Fig. 6 show that a material having AlN on the surface thereof can be prepared by using aluminum or an aluminum alloy in which CuAl₂ is present.

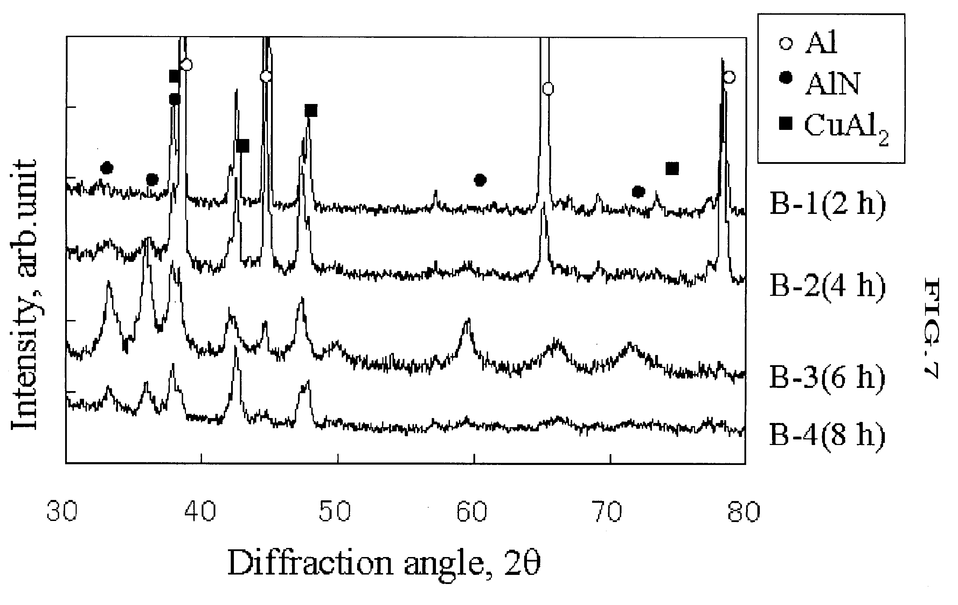

Fig. 7 is a graph showing the results of X-ray diffraction analysis (incident angle: 1°) of B-1 to B-4 prepared using an Al-6Cu-0.5Mg alloy as a base material by changing the time required for plasma nitriding treatment to 2 hours, 4 hours, 6 hours and 8 hours. Fig. 7 shows that when the treating time is longer, the peak of Al is relatively smaller and the peak of AlN is relatively larger, suggesting that AlN is formed on the surface of the base material. Also, the peak of CuAl₂ is confirmed at any time during treating, suggesting that CuAl₂ is present on the surface of base material or in its vicinity regardless of the plasma nitriding time and that the above CuAl₂ promotes the formation of AlN.

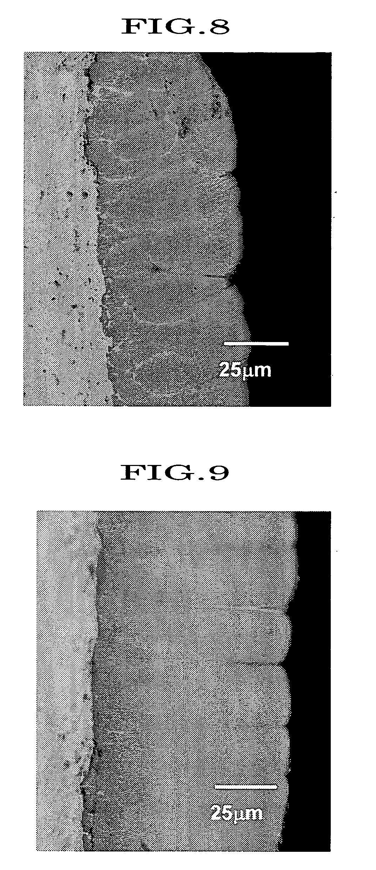

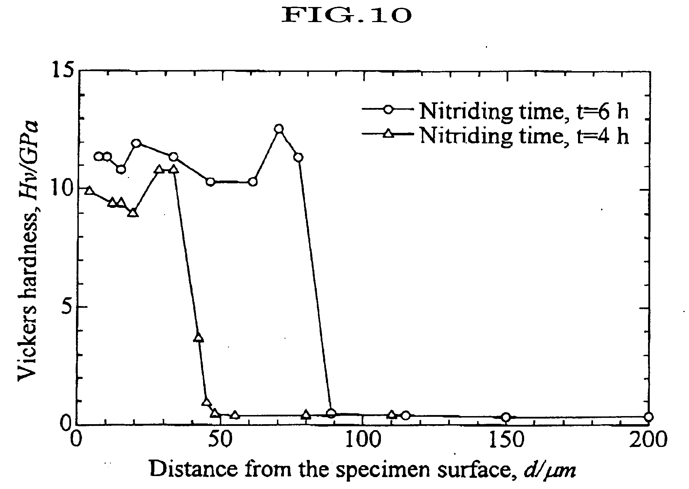

Fig. 8 and Fig. 9 show sectional SEM images of B-2 and B-3. Fig. 10 shows the results of measurement of the hardness (Vickers Hardness) of each section of B-2 and B-3. In Fig. 10, the abscissa is a distance (µm) from the surface of B-2 or B-3 and the ordinate is Vickers hardness (unit: GPa).

Figs. 8, 9 and 10 show that the thickness of the AlN layer in B-2 (nitriding time: 4 hours) is about 40 µm and the thickness of the AlN layer in B-3 (nitriding time: 6 hours) is about 80 µm. Figs. 8 and 9 also show that the base material is adhesive to the AlN layer. Further, white regions are observed in the AlN layer in Figs. 8 and 9. These white regions are confirmed to be CuAl₂ by energy dispersion type X-ray analysis.

Accordingly, a highly adhesive and thick AlN layer is formed on the surface of the aluminum alloy in a short time by way of the present examples. It is also considered that the presence of CuAl₂ promotes the formation of AlN.

## Claims

1. A process of producing an aluminum material having an aluminum nitride (AlN) region on the surface thereof, comprising the steps of:
preparing an aluminum material containing CuAl₂; and
plasma nitriding the aluminum material, to thereby form an AlN region on the surface of the aluminum material.

2. The process according to Claim 1, further comprising a step of sputtering the aluminum material to remove Al₂O₃ present on the surface of the aluminum material prior to the plasma nitriding step.

3. The process according to Claim 1 or 2, wherein the plasma nitriding step is carried out at -167 to 630°C.

4. The process according to any one of Claims 1 to 3, wherein the plasma nitriding step comprises a treating step which consists of a step of applying a pulse voltage of -50 V to -50 kV for 0.1 µs to 10 ms followed by a application suspending step having 0.1 µs to 100 ms; or a treating step which comprises a step of applying a continuous D.C. voltage of -50 to -800 V, in an activated first nitriding gas atmosphere.

5. The process according to Claim 4, wherein the first nitriding gas is a gas made from nitrogen and hydrogen and/or a gas comprising nitrogen gas and hydrogen gas.

6. The process according to any one of Claims 1 to 5, wherein AlN is produced at a rate of 0.05 µm/hour or more in the plasma nitriding step.

7. The process according to any one of Claims 2 to 6, wherein the sputtering step is carried out using the aluminum material as the negative electrode by applying a D.C. voltage of -50 V to -4000 V in an atmosphere of chemically activated second nitriding gas.

8. The process according to any one of Claims 1 to 7, wherein CuAl₂ is contained in the AlN region of the obtained aluminum material.

9. An aluminum material having an AlN region on the surface thereof, wherein the AlN region has CuAl₂.

10. An aluminum material having an AlN region on the surface thereof, wherein CuAl₂ is finely dispersed in the AlN region.

11. The material according to Claim 9 or 10, wherein the AlN region has a thickness of 0.1 µm or more.

12. The material according to any one of Claims 9 to 11, wherein the AlN region is grown at a rate of 0.05 µm/hour or more.

13. The material according to any one of Claims 9 to 12, wherein the AlN region has a Vickers hardness (Hv) of 4 GPa or more.

14. The material according to any one of Claims 9 to 13, wherein the AlN region has a thermal conductivity of 100 W/mK or more.

15. The material according to any one of Claims 9 to 14, wherein the tensile fracture strength between the AlN region and the aluminum material is not less than the tensile fracture strength of the aluminum material and is 15 GPa or less.
